# EUROPEAN PATENT APPLICATION

(11) **EP 1 622 192 A1**
(43) Date of publication of application: **01.02.2006**
(21) Application number: 04730676.6
(22) Date of filing: 30.04.2004
(51) Int. Cl.: H01L 21/205, H01L 21/68, C23C 16/44

(54) **SUBSTRATE TRANSFER DEVICE OF THIN-FILM FORMING APPARATUS**

(30) Priority: 02.05.2003 JP 2003126960
(71) Applicant: Ishikawajima-Harima Heavy Industries Co., Ltd., Chiyoda-ku, Tokyo 100-8182 (JP)
(72) Inventor: YAMASAKI, S., Ishikawajima-Harima Heavy Ind. Co.,, Tokyo 1008182 (JP); HASEGAWA, N., Ishikawajima-Harima Heavy Ind. Co.,, Tokyo 1008182 (JP)
(74) Representative: Zinsinger, Norbert
(86) International application number: PCT/JP2004/006313
(87) International publication number: WO 2004/097912

(57) **Abstract**

Disclosed is a substrate transfer device for a thin-film deposition apparatus. In order to positively prevent plasma generated by electrodes (3) from coming into a rear surface of the substrate (4) and to attain cost reduction and improvement in maintenance without providing a mask panel (35) in a deposition chamber (1) with which the whole outer peripheral edge of the substrates (4) is masked, partition panels (37) each with an opening (36) larger than substrate (4) and facing the electrode (3) are arranged on a transfer carriage (23), a picture-frame-like substrate holder (38) with the substrate (4) fitted thereto being arranged on a side of the partition panel away from the electrode (3) such that the substrate (4) is arranged substantially at a center of the opening (36) of the partition panel (37) and the outer peripheral edge of the substrate holder (38) is masked with the partition panel (37).

## Description

### Technical Field

The present invention relates to a substrate transfer device for a thin-film deposition apparatus in which thin films of for example silicon are uniformly deposited on substrates through plasma CVD.

### Background Art

A photovoltanic module is attracting attention and prospective as a clean energy source; but, cost reduction is indispensable for promoted dissemination thereof. Thus, a thin-film deposition apparatus has been strongly desired which can deposit silicon films with uniform thickness on large-sized substrates in a single operation, thereby attaining high mass productivity. For deposition of thin film of for example silicon, a parallel plate (capacitively coupled) plasma CVD apparatus has been practically used. The apparatus has a problem in its low processing capacity since it can usually treat with only a single substrate; to concurrently treat with a plurality of substrates by the apparatus would result in extreme increase in size of the apparatus. Moreover, increase in size of the substrate would bring about extreme nonuniformity in thickness of thin film deposited, failing to obtain a photovoltanic module with desired characteristics.

In order to deposit thin film with high uniformity in thickness, plasma with uniform density must be formed over the substrate; to this end, various researches and investigations have been made. However, it is not easy for parallel plate electrodes to form plasma with uniform density when a substrate is of large-sized. More specifically, in order to form plasma with uniform density for parallel plate electrodes, it is required with respect to a substrate as a whole to arrange the two electrodes with their distance being accurately maintained; this is not easy and becomes further difficult when a substrate is large-sized. Moreover, in the parallel plate electrode system, electric discharge between a high-frequency applied electrode on one hand and an opposite electrode with ground potential and a wall of a deposition chamber on the other hand will disadvantageously cause the electrodes to have self-bias potential, resulting in distribution caused in plasma density (see, for example, US Patent 5,437,895). Moreover, large-sized electrodes may cause standing waves to be generated on surfaces thereof, resulting in distribution of plasma caused.

Then, a plasma CVD method, using inductive coupling type electrodes, has been proposed which has a plasma maintaining mechanism entirely different from that of parallel plate electrode system, which is free from specific problems of the above-mentioned parallel plate electrode system such as required accuracy in distance between electrodes and self-bias of the electrodes and which can generate higher plasma density, using high frequency of VHF band advantageous for high-speed deposition.

However, the above-mentioned inductive coupling type electrodes with for example a ladder shape or zigzag folded shape tend to have nonuniform current path and have partially standing waves at unexpected locations when they are large-sized in accordance with a large-sized substrate, which makes it difficult to realize the plasma with uniform density. Thus, it has been difficult to cope with a large-sized substrate, using any conventional electrode structure.

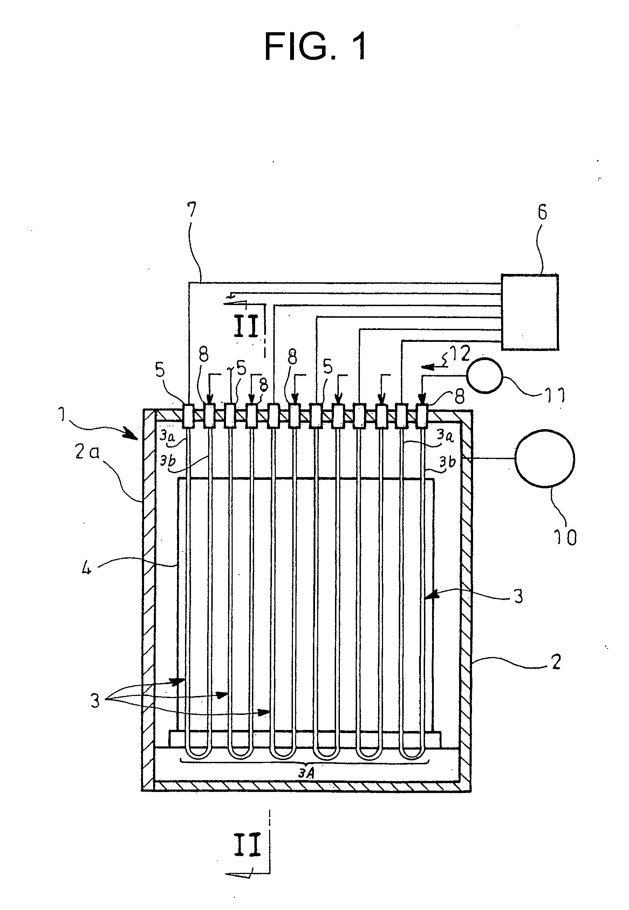

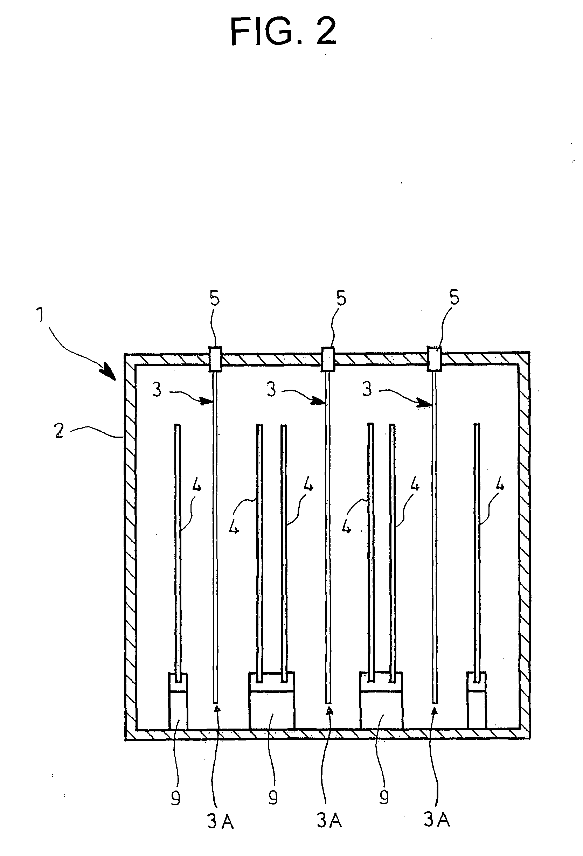

Thus, there has been developed a thin-film deposition apparatus which can effectively and concurrently deposit silicon films with uniform thickness on a plurality of large-sized substrates without enlargement of the apparatus, thereby enhancing productivity. This thin-film deposition apparatus has, as shown in Figs. 1 and 2, a plurality of (three in the example of Fig. 2) arrays 3A of inductive coupling type electrodes (each array comprising six electrodes in Fig. 1) arranged within walls 2 of the deposition chamber 1.

Each of the electrodes 3 comprises feed and ground parts 3a and 3b and is of substantially U-shaped, the U-shaped electrodes being arranged in single plane with required spacing to each other to thereby provide an electrode array depending upon width of the substrate 4.

Each of the substantially U-shaped electrodes 3 has the feed part 3a with its end connected to a feed inner conductor of a feed-side connector 5 which in turn is arranged in the wall 2 on a top of the deposition chamber 1, the feed inner conductor being connected to a high-frequency feeding core body of a coaxial cable 7 connected to a high frequency power source 6. Each of the electrodes 3 has the ground part 3b with its end grounded to the wall 2 by a ground conductor of a ground-side connector 8 in the wall 2. An outer conductor of the feed-side connector 5 is grounded to the wall 2 and is connected to an outer conductor covering the core body of the coaxial cable 7, whereby the outer conductor is grounded to effect emission shield for the high-frequency power. In order to supply high frequency power of alternately reversed phases to the feed parts 3 of the adjacent electrodes 3, a phase shifter (not shown) may be arranged between the feed-side connector 5 and the high frequency power source 6. A function generator (not shown) is connected to the high frequency power source 6 so as to apply desired AM modulation to the high-frequency power outputted from the power source 6.

Such thin-film deposition apparatus has, as shown in Fig. 1, the electrodes 3 (electrode arrays 3A) arranged in accordance with the width of the substrate 4, are arranged in a plural (three in Fig.2) arrays with required spacing with each other as shown in Fig. 2, the substrates 4 being arranged on opposite sides of each of the electrodes 3; this structure makes it possible to concurrently deposit thin films on a number of (six in Fig. 2) substrates 4, thereby improving productivity. A front wall 2a (left-side wall in Fig. 1) of the deposition chamber 1 is constructed to be selectively opened and closed; by opening the front wall 2a, the substrate 4 may be transported onto and discharged from the substrate support 9.

An interior of the deposition chamber 1 is connected to the vacuum pumping device 10 so as to be internally evacuated; to this end, the deposition chamber 1 is constructed airtight.

The ground-side connector 8 is externally connected to a gas supply source 11 so as to feed the source gas 12 such as silane for deposition of films through interiors of the ground parts 3b constitutive of pipes of the electrodes 3.

In the thin-film deposition apparatus shown in Figs. 1 and 2, the substrates 4 are arranged on opposite sides of the electrodes 3 arranged in plural arrays, the interior of the deposition chamber 1 being kept at a vacuum by the vacuum pumping device 10 and the source gas 12 such as silane for film deposition being fed from the gas supply source 11. In this state, high-frequency power is fed by the high frequency power source 6 to the electrodes 3 to generate plasma around the feed and ground parts 3a and 3b, thereby depositing thin films of silicon with uniform thickness on the substrates 4.

The above-mentioned thin-film deposition apparatus is disclosed for example in JP 2002-69653 A.

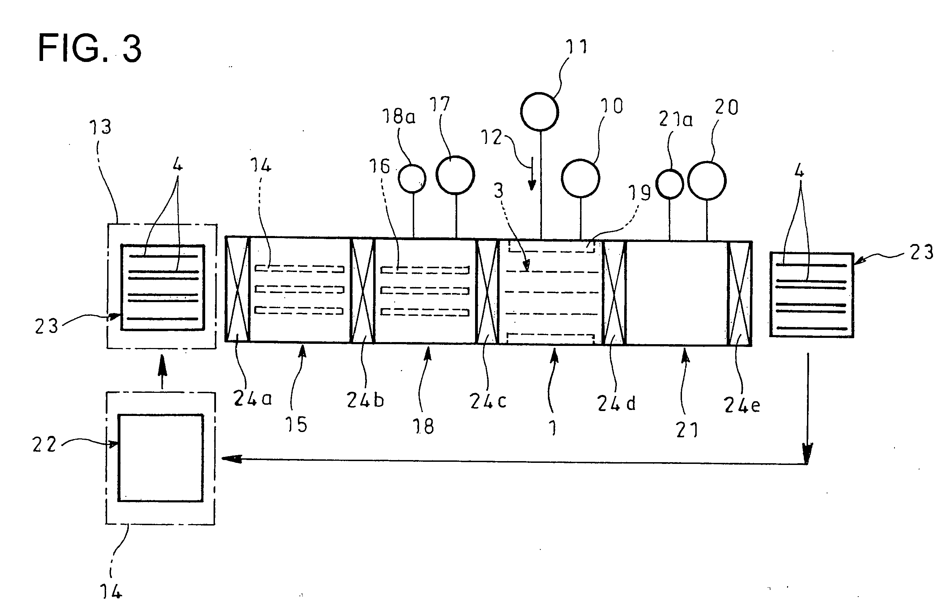

In the thin-film deposition apparatus with the single deposition chamber 1 as shown in Figs. 1 and 2, the operation of depositing the thin films on the substrates 4 is difficult to be automated. Therefore, as shown in Fig. 3, a conventional proposal is, for example, to arrange a substrate loaded part 13, a heat part 15 with substrate heaters 14, a load lock chamber 18 with heat equalizers 16, a vacuum pumping device 17 and an openable air intake 18a, a deposition chamber 1 with inductive coupling type electrodes 3, a vacuum pumping device 10, a gas supply source 11 and a temperature controller 19, an unload lock chamber 21 with a vacuum pumping device 20 and an openable air intake 21a and a substrate discharge part 22; a transfer carriage 23 which can carry the substrates 4 is transported via the substrate loaded part 13, the heat part 15 and the load lock chamber 18 into the deposition chamber 1, moved via the unload lock chamber 21 to the substrate intake 22 and returned to the substrate loaded part 13, thereby providing the thin-film deposition apparatus. In Fig. 3, reference numerals 24a and 24e designate gate valves for interception from outside for loading and unloading, respectively. In Fig. 3, reference numerals 24b, 24c and 24d denotes gate valves for mutual interception between the heat part 15, the load lock chamber 18, the deposition chamber 1 and the unload lock chamber 21.

When thin films are to be deposited on the substrates 4, first of all, the substrates 4 are carried on the carriage 23 in the substrate loaded part 13.

The substrates 4 carried on the carriage 23 are transferred to the heat part 15 with the gate valve 24a being opened. Then, the gate valve 24a is closed and the substrates are uniformly heated by the substrate heaters 14 to a predetermined temperature.

The substrates 4 heated in the heat part 15 are transferred to the load lock chamber 18 with the gate valve 24b being opened. Then, the gate valve 24b is closed and the load lock chamber 18 is evacuated by the vacuum pumping device 17 while the temperature of the substrates 4 is maintained by the heating equalizers 16 to the predetermined temperature.

Then, the gate valve 24c is opened and the substrates 4 are transferred to the deposition chamber 1. After the gate valve 24c is closed, silicon films are deposited on the substrates 4 by operating the electrodes 3 while the predetermined pressure is maintained by the vacuum pumping device 10 and the source gas 12 such as silane is fed by the gas supply source 11.

After the film deposition on the substrates 4 is completed, the gate valve 24d is opened and the substrates 4 are transferred to the unload lock chamber 21. At this time, the pressure of the interior of the unload lock chamber 21 has been previously reduced to negative pressure same as that of the deposition chamber 1 by the vacuum pumping device 20; when the substrates 4 are transferred out to the unload lock chamber 21, the gate valve 24d is closed.

Then, the air intake 21a is opened to rise the pressure in the unload lock chamber 21 to the atmospheric pressure, and the gate valve 24e is opened. In the state, the substrates 4 on the carriage 23 are transferred out. Then, the carriage 23 is moved to the substrate discharge part 22 and the substrates 4 with the films deposited thereon are taken out and withdrawn. When next substrates 4 are to be transferred to the load lock chamber 18 which has been reduced in pressure, the air intake 18a is opened to raise the pressure of the load lock chamber 18 to the atmospheric pressure, and then the gate valve 24b is opened.

The carriage 23 used as substrate transfer device for the thin-film deposition apparatus shown in Fig. 3 is conventionally constructed such that, as shown in Figs. 4 and 5, support posts 28 with required spacing from each other in a direction of travel of the carriage are arranged on a carriage body 27 movable via wheels 26 on guide rails 25; claw members 29 for retaining engagement with the substrates 4 are mounted on surfaces of the posts 28 facing the electrodes 3 so that the substrates 4 are retained and extend between the posts 28, whereby surfaces of the substrates 4 face the electrodes 3.

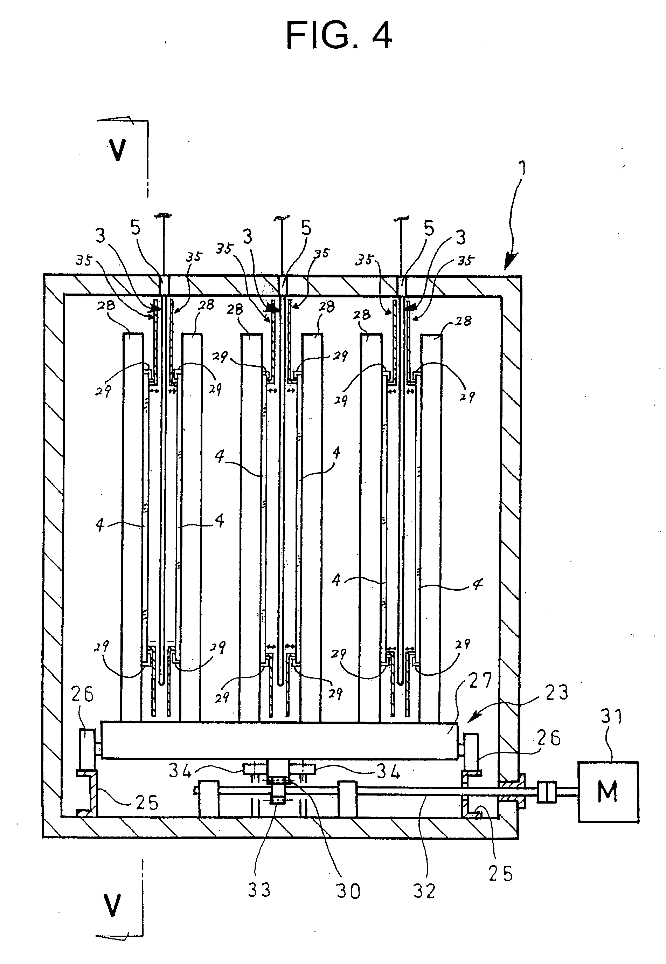

In the example shown in Fig. 4, a plurality of (three in the example shown in Fig. 4) arrays of electrodes 3 are arranged in the deposition chamber 1 with required mutual spacing in a horizontal direction perpendicular to the direction of travel of the carriage 23, so that plural pairs (six pairs in the example shown in Fig. 4) of support posts 28 are arranged on the body 27 of the carriage 23 to make the surfaces of the substrates 4 face the opposite surfaces of the arrayed electrodes 3.

The body 27 of the carriage 23 has a rack 30 which is arranged centrally on a lower surface of the body and which extends in the direction of travel of the carriage. The rack 30 is engaged with pinions 33 each of which is rotatively driven via a rotary shaft 32 by a drive 31 such as a motor and which are arranged in a course of travel of the carriage 23 at a pitch slightly shorter than the length of the carriage body 27. Thus, the drives 31 are sequentially driven for delivery or travel of the carriage 23. In Fig. 4, reference numeral 34 denotes guide rollers arranged intermediately of the course of travel of the carriage 23 so as to clamp opposite surface of the rack 30, whereby the carriage 23 can be stably traveled while guided by the guide rollers 34. Any stop position of the carriage 23 is detected for example by counting revolutionary numbers of the drive 31 or by screening light axis of any one of optical sensors (not shown) arranged at predetermined positions through the carriage 23; on the basis of the detected result, rotations of the drives 31 are stopped to stop the carriage 23 at a predetermined position.

When the thus constructed carriage 23 is to be used as substrate transfer device to transfer the substrates 4 to the deposition chamber 1 to deposit thin films of for example silicon on the substrates 4, square-frame-shaped mask panels 35 have to be arranged in the chamber 1 movably toward and away from the substrates 4 for prevention of the plasma from coming into rear surfaces of the substrates 4.

More specifically, when the substrates 4 are to be transferred by the carriage 23 into and out of the deposition chamber 1, the mask panels 35 are withdrawn from the positions shown in Fig. 4 toward the electrodes 3 so as to prevent its interference with passing of the substrates 4; when thin films are to be deposited on the substrates 4, the mask panels 35 have to be moved in positions shown in Fig. 4 for masking of outer peripheral edges on the substrates 4 with them, thereby preventing the plasma generated by the electrodes 3 from coming into the rear surfaces of the substrates 4.

As mentioned above, in order to prevent the plasma generated by the electrodes 3 from coming into the rear surfaces of the substrates 4, the mask panels 35 are indispensable which are large enough for masking of the whole outer peripheral edges on the substrates 4 with them; moreover, a gap between the mask panel and the substrate 4 must be suppressed to minimum. It is, however, difficult to arrange such large mask panels 35 in the deposition chamber 1 with high accuracy, disadvantageously leading to increase in cost.

Such mask panels 35 may, moreover, have thin films of for example silicon attached thereto which may drop to hinder uniform deposition of thin films on the substrates 4. Therefore, an operation of removing the thin films attached to the mask panels 35 must be carried out regularly. However, because of extremely short gap between the mask panel 35 and the electrode 3, the removal operation cannot be efficiently effected, leading to deteriorated maintenance.

In view of the above, the present invention has its object to provide a substrate transfer device for a thin-film deposition apparatus which can ensure prevention of the plasma generated by the electrodes from coming into the rear surfaces of substrates without arranging large-sized mask panels enough for masking of the whole outer peripheral edges of the substrates in the deposition chamber, thereby attaining cost reduction and enhancing maintenance.

### Summary of The Invention

The present invention is directed to a substrate transfer device for a thin-film deposition apparatus wherein substrates on a transfer carriage are transferred into a deposition chamber with electrodes arranged in single plane so as to make surfaces of the substrates face the electrodes for deposition of thin films on the substrates,
characterized in that partition panels each with an opening larger than the substrate and facing the electrode are arranged on the transfer carriage, a picture-frame-like substrate holder with the substrate fitted therein being arranged on a side of each of the partition panels away from the electrode such that the substrate is positioned substantially at a center of the opening of the partition panel and that an outer peripheral edge on the substrate holder is masked with the partition panel.

According to the above-mentioned means, the following operation will be attained.

With the substrate being fitted into the picture-frame-like substrate holder and said substrate holder with the substrate fitted thereto being arranged on a side of the partition panel on the transfer carriage away from the electrode, the substrate is positioned substantially at the center of the opening of the partition panel, an outer peripheral edge of the substrate holder being masked with the partition panel; in such state, the carriage is transferred into the deposition chamber so as to make the surfaces of the substrates face the electrodes, plasma being generated by the electrodes for deposition of thin films on the surfaces of the substrates.

Gaps between the substrate and substrate holder and between the substrate holder and partition panel may be readily suppressed to minimum, so that the plasma is positively prevented from coming into the rear surface of the substrate by the substrate holder and partition panel; there is no need to provide a mask panel large enough for masking of the whole outer peripheral edge of the substrate and there is no need to arrange such large mask panel in the deposition chamber movably and with high accuracy, which may contribute to cost reduction.

Thin films of for example silicon may be attached to the surfaces of the substrate holders and partition panels, and dropping of such thin films therefrom may block deposition of uniform thin films on the substrates. As a result, there is a need to regularly carry out an operation of removing any thin films attached to the substrate holders and partition panels. Since the substrate holders and partition panels are mounted on the transfer carriage and can be transferred out of the deposition chamber, the operation of removing any thin films attached to the surfaces of the substrate holders and partition panels can be efficiently carried out outside of the deposition chamber, thereby attaining good maintenance.

In the substrate transfer device for the thin-film deposition apparatus, the plural arrays of electrodes may be arranged in the deposition chamber horizontally with required spacing with each other in a direction perpendicular to the direction of travel of the carriage and the plural partition panels may be arranged on the carriage such that the substrates face opposite surfaces of the respective electrodes, which is advantageous in concurrently depositing thin films on the plural substrates and improving the productivity.

In the substrate transfer device for the thin-film deposition apparatus, each of the partition panels may be mounted on the carriage so as to extend between support posts arranged to be spaced apart with required spacing from each other in the direction of travel of the carriage, and projections from the substrate holder may be engaged with mating members projecting from the support posts, which makes it easy to mount and demount the substrate holder with the substrate fitted thereto to and from the carriage through robot arms, thereby facilitating automation of the deposition process.

In the substrate transfer device for the thin-film deposition apparatus, an inner peripheral edge of the rear surface of the substrate holder is formed with a retention groove into which an outer peripheral edge of the substrate is fitted; a holding tool may be mounted to press and support the outer peripheral edge of the rear surface of the substrate fitted into the retention groove. As a result, the substrate can be more positively fitted to the substrate holder.

In the substrate transfer device for the thin-film deposition apparatus, the electrode may be an inductive coupling type electrode which is centrally folded to have U-shape and which has at its opposite ends feed and ground parts.

### Brief Description of Drawings

- Fig. 1: is a side elevation in section of a conventional thin-film deposition apparatus;
- Fig. 2: is a front elevation in section of the conventional thin-film deposition apparatus and corresponds to a view looking in arrows II in Fig. 1;
- Fig. 3: is a plan view showing an overall schematic flow of the conventional thin-film deposition apparatus proposed for automated thin-film deposition onsubstrates;
- Fig. 4: is a front elevation in section of a conventional substrate transfer device for the thin-film deposition apparatus;

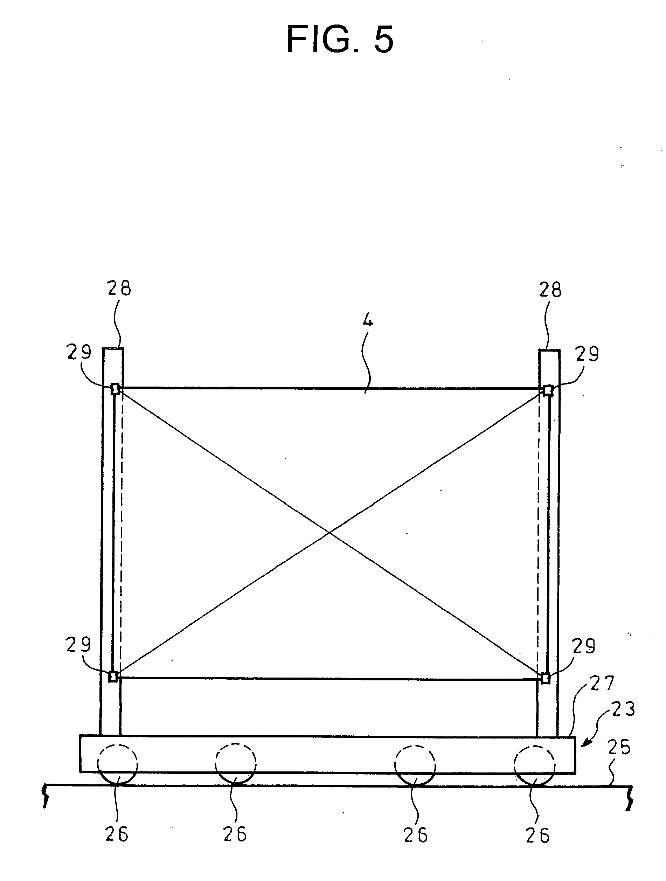

- Fig. 5: is a side elevation in section of the conventional substrate transfer device for the thin-film deposition apparatus and corresponds to a view looking in arrows V in Fig. 4;

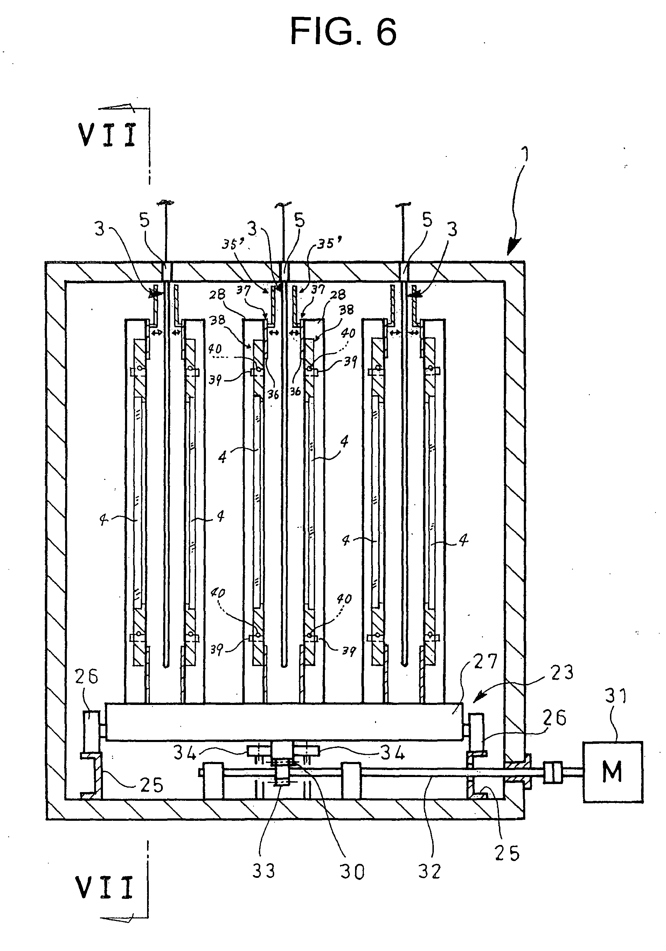

- Fig. 6: is a front elevation in section of an embodiment according to the invention;

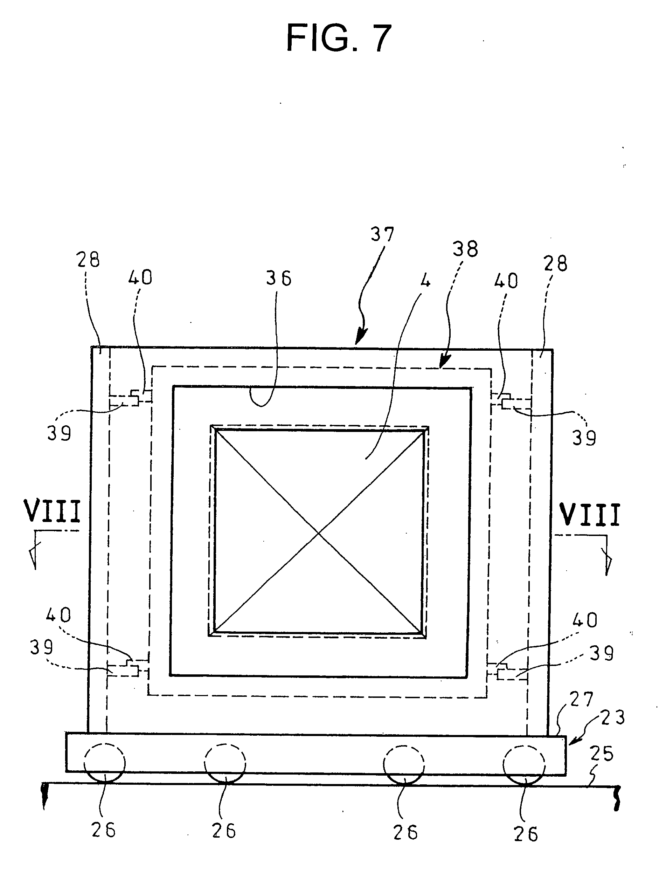

- Fig. 7: is a side elevation in section of the embodiment according to the invention and corresponds to a view looking in arrows VII in Fig. 6;

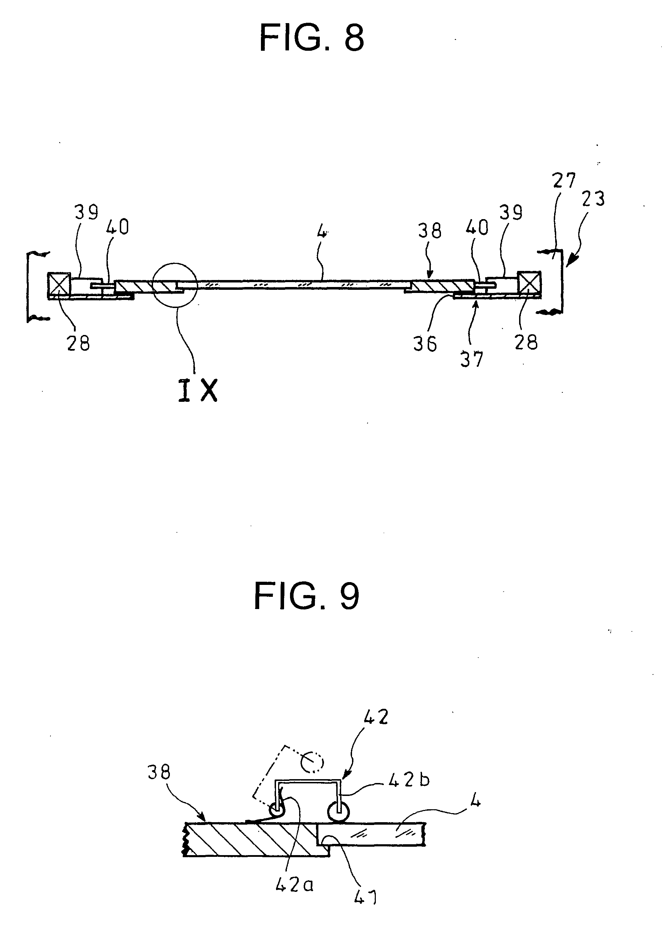

- Fig. 8: is a sectional view taken along lines VIII-VIII in Fig. 7;
- Fig. 9: is a plan view of a holding tool for a substrate in a substrate holder in the embodiment of the invention which corresponds to part IX in Fig. 8;

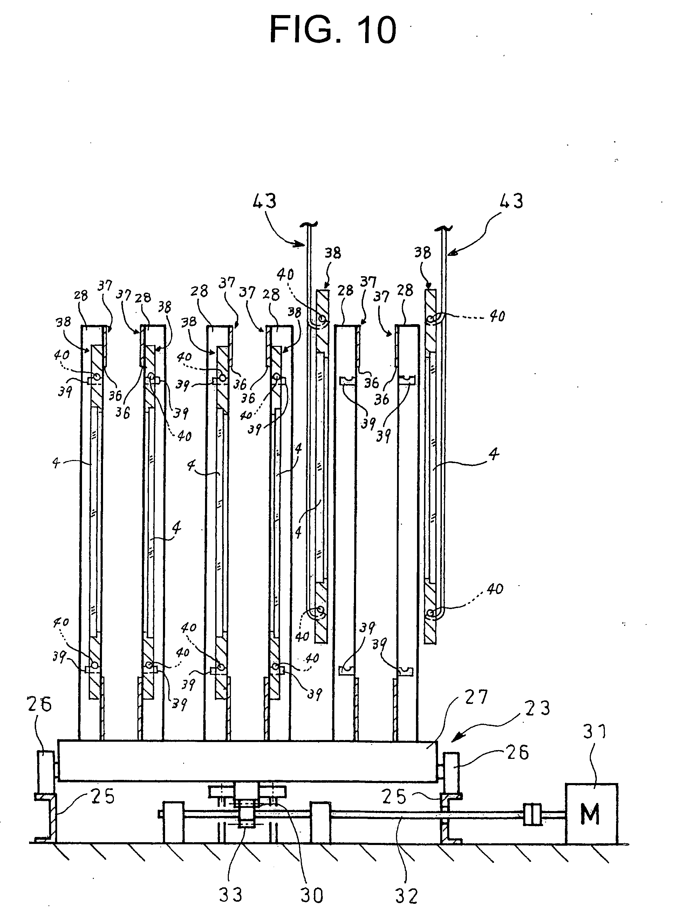

- Fig. 10: is a front elevation in section showing mounting and demounting of the substrate holders by robot arms in the embodiment of the invention; and

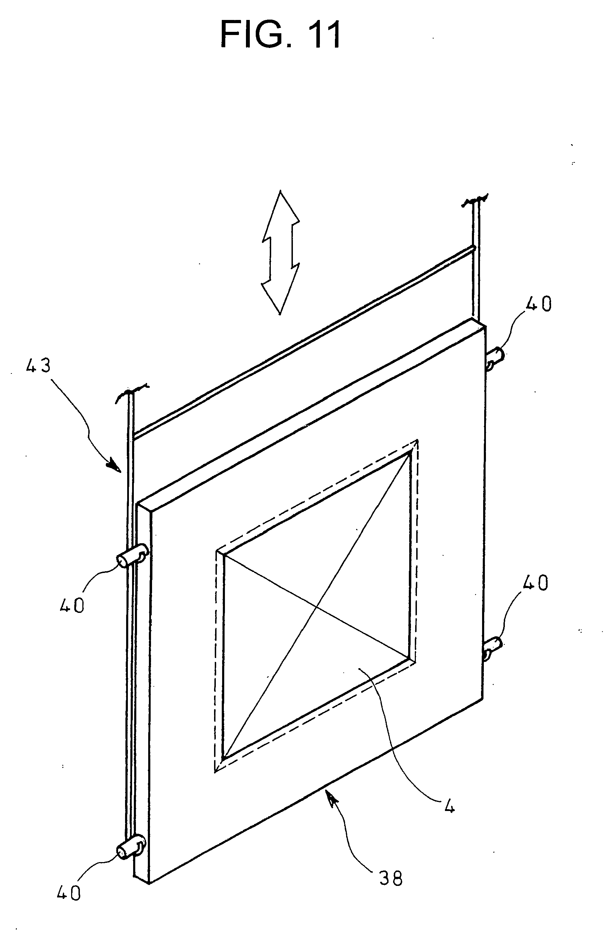

- Fig. 11: is a perspective view showing mounting and demounting of the substrate holders by robot arms in the embodiment of the invention.

### Best Mode for Carrying Out the Invention

An embodiment of the invention will be described in conjunction with the drawings.

Figs. 6-11 show the embodiment of the invention in which parts similar to those in Figs. 3-5 are represented by the same reference numerals. The embodiment is similar in basic structure to the conventional one shown in Figs. 3-5 and is characterized in that, as shown in Figs. 6-11, partition panels 37 are arranged on a transfer carriage 23, each of said partition panels having an opening 36 larger than a substrate 4 and facing an inductive coupling type electrode 3, each of the partition panels 37 having on its side away from the electrode 3 a picture-frame-like substrate holder 38 with the substrate 4 fitted thereto such that the substrate 4 is situated substantially at a center of the opening 36 and an outer peripheral edge of the holder 38 is masked with the panel 37.

In the embodiment, a plurality of (three in the example of Fig. 6) arrays of electrodes 3 are arranged in the deposition chamber 1 to be horizontally spaced apart from each other with required spacing in a direction perpendicular to a direction of travel of the carriage 23, whereby the plural (six in the example of Fig. 6) panels 37 are arranged on the carriage 23 such that the substrates 4 face opposite sides of the electrodes 3.

The partition panels 37 are mounted on the carriage 23 to extend between support posts 28 which in turns are arranged on the carriage 23 with required spacing in the direction of travel of the carriage, pins 40 as projections from the substrate holder 38 being engaged with their mating members 39 projecting from the post 28.

Moreover, as shown in Fig. 9, an inner peripheral edge of the rear surface of the holder 38 is formed with a retention groove 41 into which the outer peripheral edge of the substrate 4 is fitted, a holding tool 42 being mounted which presses and supports the outer peripheral edge of the rear surface of the substrate 4 fitted to the retention groove 41. The holding tool 42 comprises a clamp member 42b pushed against the outer peripheral edge of the rear surface of the substrate 4 by spring force of a spring 42a, the holding tools 42 being arranged on plural positions on the inner peripheral edge of the rear surface of the substrate holder 38.

In the deposition chamber 1, as shown in Fig. 6, a mask panels 35' with which only an upper edge of the partition panel 37 is masked are arranged to be moved toward and away from the partition panel 37.

In Figs. 10 and 11, reference numeral 43 denotes robot arms each of which loads and lifts the pin 40 as the projection of the holder 38 on and from the mating part 39 of the post 28. Next, mode of operation of the above embodiment will be described.

With the substrate 4 being fitted into the picture-frame-like substrate holder 38 and said substrate holder 38 with the substrate 4 fitted thereto being arranged on a side of the partition panel 37 on the carriage 23 away from the electrode 3, the substrate 4 is positioned substantially at the center of the opening 36 of the partition panel 37, the outer peripheral edge of the substrate holder 38 being masked with the partition panel 37. In such state, the carriage 23 is transferred into the deposition chamber 1 so as to make the surfaces of the substrates 4 face the electrodes 3, plasma being generated by the electrodes 3 for deposition of thin films on the substrates 4.

Gaps between the substrate 4 and the substrate holder 38 and between the substrate holder 38 and partition panel 37 may be readily suppressed to minimum, the plasma being positively prevented from coming into the rear surface of the substrate 4 by the substrate holder 38 and partition panel 37 so that, as shown in Fig. 6, it suffices in the deposition chamber 1 to provide only a mask panel 35' with which only an upper edge of the partition panel 37 is masked; there is no need to provide a mask panel 35 (see Fig. 4) large enough for masking of the whole outer peripheral edge of the substrate 4 and there is no need to arrange such large mask panel 35 in the deposition chamber 1 movably and with high accuracy, which may contribute to cost reduction.

Thin films of for example silicon may be attached to the surfaces of the substrate holders 38 and partition panels 37, and dropping of such thin films therefrom may block deposition of uniform thin films on the substrates 4. As a result, there is a need to regularly carry out an operation of removing any thin films attached on the substrate holders 38 and partition panels 37. Since the substrate holder 38 and the partition panel 37 are mounted on the transfer carriage 23 and can be transferred out of the deposition chamber 1, the operation of removing any thin films attached to the surfaces of the substrate holders 38 and partition panels 37 can be efficiently carried out outside of the deposition chamber 1, thereby attaining good maintenance.

In the present embodiment, the plural arrays of electrodes 3 are arranged in the deposition chamber 1 to be horizontally spaced apart from each other with required spacing in the direction perpendicular to the direction of travel of the carriage 23, and the plural partition panels 37 are arranged on the carriage 23 such that the substrates 4 face opposite surfaces of the respective electrodes 3, which is advantageous in concurrently depositing thin films on the plural substrates 4 and improving the productivity.

Moreover, in the present embodiment, each of the partition panels 37 is mounted on the carriage 23 so as to extend between the support posts 28 arranged to be spaced apart with required spacing in the direction of travel of the carriage, the pins 40 as projects from the substrate holder 38 being engaged with mating members 39 projecting from the support posts 28. As a result, the substrate holders 38 with the substrates 4 fitted therein can be readily mounted and demounted on and from the carriage 23, as shown in Figs. 10 and 11, by the robot arms 43, thereby facilitating automation of the deposition process.

Moreover, in the present embodiment, as shown in Fig. 9, the inner peripheral edge on the rear surface of the substrate holder 38 is formed with the retention groove 41 into which the outer peripheral edge of the substrate 4 is fitted, the holding tool 42 being mounted to press and support the outer peripheral edge on the rear surface of the substrate 4 fitted into the retention groove 41; as a result, the substrate 4 can be more positively fitted to the substrate holder 38.

Thus, without providing the mask panel 35 large enough for masking of the whole outer peripheral edge of the substrate 4 in the deposition chamber 1, plasma generated by the electrodes 3 can be positively prevented from coming into the rear surface of the substrates 4, thereby attaining cost reduction and improvement in maintenance.

It is to be understood that a substrate transfer device for a thin-film deposition apparatus according to the invention is not limited to the above embodiment and that various changes and modifications may be made without departing from the scope of the invention.

### Industrial Applicability

As is clear from the above, a substrate transfer device for a thin-film deposition apparatus according to the invention is suitable for deposition of uniform thin films of for example silicon on large-sized substrates in a single operation and for obtaining of a phtovoltanic module with desired characteristics.

## Claims

1. A substrate transfer device for a thin-film deposition apparatus wherein substrates on a transfer carriage are transferred into a deposition chamber with electrodes arranged in single plane so as to make surfaces of the substrate face the electrodes for deposition of thin films on the surfaces of the substrates,
**characterized in that** partition panels each with an opening larger than the substrate and facing the electrode are arranged on the transfer carriage, a picture-frame-like substrate holder with the substrate fitted therein being arranged on a side of each of the partition panels away from the electrode such that the substrate is positioned substantially at a center of the opening of the partition panel and that an outer peripheral edge of the substrate holder is masked with the partition panel.

2. The substrate transfer device for the thin-film deposition apparatus according to claim 1, wherein a plurality of arrays of electrodes are arranged horizontally with required spacing from each other in a direction perpendicular to a direction of travel of the carriage in the deposition chamber, a plurality of partition panels being arranged on the carriage so that surfaces of the substrates face opposite surfaces of the respective electrodes.

3. The substrate transfer device for the thin-film deposition apparatus according to claim 2, wherein support posts are arranged on the transfer carriage to be spaced apart from each other with required spacing in the direction of travel of the carriage, partition panels being mounted to extend over the support posts, projections from the substrate holder being engaged with mating members projecting from the support posts.

4. The substrate transfer device for the thin-film deposition apparatus according to claim 3, wherein an inner peripheral edge on a rear surface of the substrate holder is formed with a retention groove into which an outer peripheral edge of the substrate is fitted, a holding tool being mounted to press and support the outer peripheral edge on the rear surface of the substrate fitted into the retention groove.

5. The substrate transfer device for the thin-film deposition apparatus according to claim 1, wherein each of the electrodes is an inductive coupling type electrode centrally folded to have substantially U-shape and having feed and ground parts at its opposite ends.

6. The substrate transfer device for the thin-film deposition apparatus according to claim 2, wherein each of the electrodes is an inductive coupling type electrode centrally folded to have substantially U-shape and having feed and ground parts at its opposite ends.

7. The substrate transfer device for the thin-film deposition apparatus according to claim 3, wherein each of the electrodes is an inductive coupling type electrode centrally folded to have substantially U-shape and having feed and ground parts at its opposite ends.

8. The substrate transfer device for the thin-film deposition apparatus according to claim 4, wherein each of the electrodes is an inductive coupling type electrode centrally folded to have substantially U-shape and having feed and ground parts at its opposite ends.
